# EUROPEAN PATENT SPECIFICATION

(11) **EP 2 135 974 B1**
(45) Date of publication and mention of the grant of the patent: **07.05.2014**
(21) Application number: 07738368.5
(22) Date of filing: 13.03.2007
(51) Int. Cl.: C23G 1/02, C23C 14/02, C23C 18/18, C25D 5/34, C23C 18/31, C23G 1/08, C23G 1/10, C25D 5/36, C25D 5/38, C25D 5/40, C25D 5/48, C25D 5/54, C23C 18/16

(54) **METHOD OF SURFACE TREATMENT FOR METALLIC GLASS PART, AND METALLIC GLASS PART WITH ITS SURFACE TREATED BY THE METHOD**
VERFAHREN ZUR OBERFLÄCHENBEHANDLUNG FÜR TEIL AUS METALLISCHEM GLAS UND TEIL AUS METALLISCHEM GLAS MIT NACH DIESEM VERFAHREN BEHANDELTER OBERFLÄCHE
PROCÉDÉ DE TRAITEMENT DE SURFACE POUR UNE PIÈCE EN VERRE MÉTALLIQUE, ET PIÈCE EN VERRE MÉTALLIQUE DONT LA SURFACE EST TRAITÉE PAR CE PROCÉDÉ

(43) Date of publication of application: 23.12.2009
(73) Proprietor: Tohoku University, Aoba-ku Sendai-shi Miyagi 980-8577 (JP); NGK Insulators, Ltd., Nagoya-shi, Aichi 467-8530 (JP)
(72) Inventor: WANG, Xin Min, Sendai-shi Miyagi 982-0261 (JP); MURAMATSU, Naokuni, Nagoya-shi Aichi 467-8530 (JP); KIUCHI, Junsuke, Sabae-shi Fukui 916-0016 (JP); SUZUKI, Hiroshi, Sabae-shi Fukui 916-0016 (JP); ARAKAWA, Tatsue, Sendai-shi Miyagi 982-0261 (JP); KIMURA, Hisamichi, Sendai-shi Miyagi 980-8577 (JP); INOUE, Akihisa, Sendai-shi Miyagi 980-8577 (JP); MAKABE, Eiichi, Sendai-shi Miyagi 983-0036 (JP)
(74) Representative: Fairbairn, Angus Chisholm
(86) International application number: PCT/JP2007/054896
(87) International publication number: WO 2008/111163

(56) References cited:
- EP-A2- 0 190 465
- JP-A- 52 088 551
- JP-A- 2007 077 475
- JP-B1- 49 034 570
- US-A- 4 128 459

## Description

### Background of the Invention

### Field of the Invention

The present invention relates to a metallic glass component with its surface layer having both chromatic color properties and durability of a film such as corrosion resistance, weathering resistance, fingerprint wiping properties, and peeling resistance, and a method for forming the surface layer.

### Description of the Related Art

Metallic glass has a composition in which an amorphous metal is formed even at a cooling temperature of not higher than 100 K/second, and there is known a method for forming a large-shaped amorphous metal (bulk metallic glass) directly from a molten metal by using already developed water hardening, arc melting, mold casting, high-pressure projection molding, suction casting, or some other methods. Metallic glass has a unique mechanical characteristic of being free from a defect as having high strength, a low Young's modulus, high corrosion resistance, and a grain boundary, which is an essential property of an amorphous metal and is not of a crystalline metal. Furthermore, it has been possible to obtain a large-sized amorphous bulk body by the above-mentioned methods, and it has been widely expected to put the bulk body into practical use.

The surface of such metallic glass is treated so as to have an added value as a component in addition to its essential, excellent mechanical characteristics and physical properties. For example, (1) anodization (e.g.

Patent Document 1) and (2) atmosphere heating oxidation (e.g. Patent Document 2) have been attempted as conventional surface treatment, and the surface has been colored by such treatment.
Patent Document 1: National Publication of International Patent Application No.2005-509090 "Improved metal frame for electronic device and flat panel display", Liquid metal Technologies
Patent Document 2: Japanese Patent Laid-Open No. 2003-166044 "Method for toning zirconium-base amorphous metal", YKK Corporation

However, (1) although anodization enables vivid coloring depending upon conditions, since it is treated with an electrochemical function, coloring has often been nonuniformly finished in the case of three-dimensionally treating a large area of the surface of a metallic glass component. Further, for the same reason, a tone of color has sometimes been changed over time despite the passivated surface.

Moreover, (2) atmosphere heating oxidation not only leads to coloring with limited chromatic colors, but also, coloring has often been nonuniformly finished in the case of three-dimensionally treating a large area of the surface of a metallic glass component. Further, there has been a drawback in that, on an oxide film formed by atmosphere heating, natural oxidation proceeds over time to bring about a change in tone of color.

Furthermore, there has also been problems in that, on a nonuniform film formed by above (1) anodization or (2) atmosphere heating oxidation, a corrosion product tends to be generated from salt or mineral floating in the air, a mineral element contained in sweat or a fingerprint when the film is touched with a hand, or the like, to bring about deterioration in appearance and durability. US-A-4128459 and EP-A-0190465 disclose methods in which metallic glass is subjected to acid pickling and then electroplated.

### Summary of the Invention

As a result of conducting extensive studies with the aim of forming a uniform film having durability and chromatic color properties that are uniform over a large area in order to solve the above-mentioned problems, the present inventors found that covering the surface of a metallic glass component with an electroplated or electroless-plated metal film enables formation of a surface layer having corrosion resistance, weathering resistance and fingerprint wiping properties, having abundant chromatic colors, and being resistant to peeling.

Further, it was also found that covering the surface of the metallic glass component with a metal deposition film formed with a dry plating method such as vacuum deposition, ion plating or sputtering enables formation of a surface layer similar to that formed by plating.

Additionally, it was found that applying and forming a transparent resin coat onto a film formed by plating or the dry plating method enables improvement in durability without impairing a chromatic color of the film itself.

Moreover, it was found that as another method, a gloss chromatic color properties can be added to the surface of the metallic glass component by means of polishing by a physical method, and further that durability against a change over time can be provided by applying and forming a transparent resin coat onto the surface. Namely,

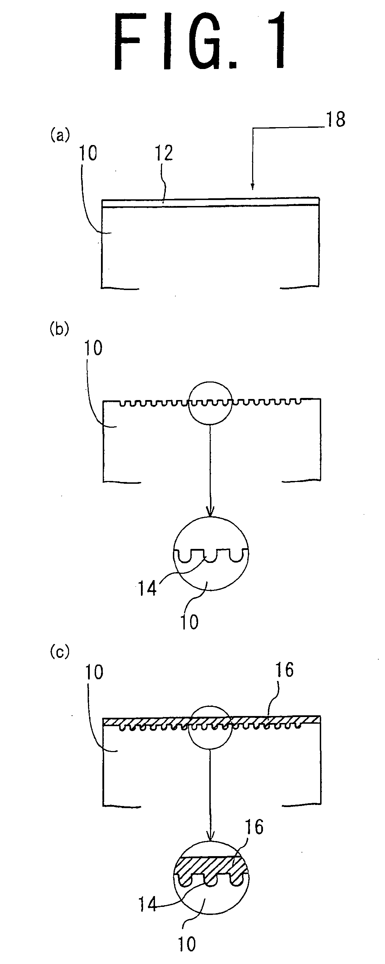

In accordance with a first aspect of the present invention, a surface treatment method (Figure 1) for a metallic glass component 10 comprises: removing an oxide film 12 on a surface of the metallic glass component 10 and providing an anchor bond shape 14 on the surface of the metallic glass component 10 by surface active treatment with a mixed aqueous solution of nitric acid and hydrofluoric acid 18 wherein a volumetric ratio of the nitric acid to the hydrofluoric acid is in a range of 2 to 5, and the mixed aqueous solution of nitric acid and hydrofluoric acid 18 has a concentration of 1 to 10 % in a volumetric ratio; and forming a plating film 16 on the surface of the metallic glass component 10 by electroplating of electroless plating.

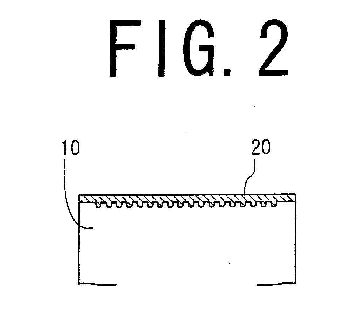

In accordance with a second aspect of the present invention, a surface treatment method (Figure 2) for a metallic glass component 10 comprises: removing an oxide film 12 on a surface of the metallic glass component 10 and providing an anchor bond shape 14 on the surface of the metallic glass component 10 by surface active treatment with a mixed aqueous solution of nitric acid and hydrofluoric acid 18 wherein a volumetric ratio of the nitric acid to the hydrofluoric acid is in a range of 2 to 5, and the mixed aqueous solution of nitric acid and hydrofluoric acid 18 has a concentration of 1 to 10 % in a volumetric ratio; and forming a metal deposition film 20 uniformly on the surface of the metallic glass component 10 by a dry plating method such as vacuum deposition, ion plating or sputtering.

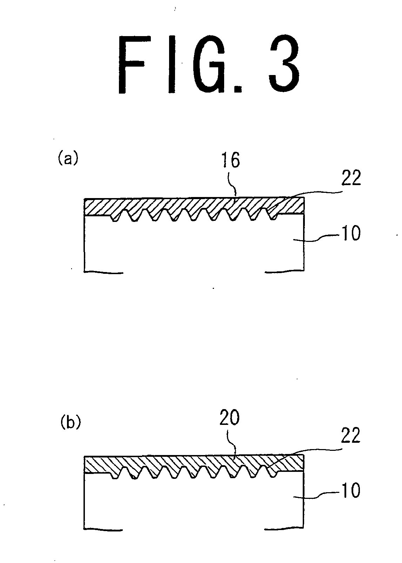

The surface treatment method (Figure 3) may be added a step: adjusting a surface roughness by physical polishing between the surface active treatment and the electroplating or the electroless plating.

The surface treatment method may be added a step: forming a transparent resin coat by applying transparent resin after the electroplating or the electroless plating.

In accordance with a third aspect of the present invention, a surface treatment method for a metallic glass component 10 comprises: removing an oxide film 12 on a surface of the metallic glass component 10 and providing an anchor bond shape 14 on the surface of the metallic glass component 10 by surface active treatment with a mixed aqueous solution of nitric acid and hydrofluoric acid wherein a volumetric ratio of the nitric acid to the hydrofluoric acid is in a range of 2 to 5, and the mixed aqueous solution of nitric acid and hydrofluoric acid 18 has a concentration of 1 to 10 % in a volumetric ratio; adding a metal gloss color to the surface of the metallic glass component by physical polishing; forming a resin coat 24 to the surface of the metallic glass component by applying resin. In this case, the resin coat 24 may be colorless transparent, or may be colored transparent.

The resin coat 24 may have a thickness of not smaller than 1 µm and not larger than 10 µm.

The metallic glass component 10 may be metallic glass of Zr group, Ti group, Cu group, Ni group, or Fe group.

In accordance with a forth aspect of the present invention, a metallic glass component 10 is treated its surface by the surface treatment method.

A functional mechanism in the above-mentioned surface treatment depends upon judgment by assumption as being the size that cannot be directly observed. A surface active treatment of previously reacted the metallic glass surface to remove the oxide film 12 on the surface with a mixed aqueous solution of nitric acid and hydrofluoric acid 18 is performed using a metallic glass's unique property that is a semi-stable liquid in a super-cooled state even at constant temperature. Then, minute holes as anchor holes in size of several atoms is provided by prompting gentle disruption of gravity while keeping a degree of freedom among a variety of atoms constituting the metallic glass. It has been found that, in formation of the plating film 16, the metal deposition film 20 and the transparent resin coat 24 which are formed after formation of the minute holes, a surface layer decoration processing layer having high adhesiveness can be secured on the surface of the metallic glass component 10 that is difficult to surface-treat, because the surface subjected to the surface active treatment is an active surface without an oxide film 12 and has excellent corrosion resistance with the assistance of the anchor effect by minute holes.

With reference to pickling treatment performed by a commercial Ti (titanium) dealer, hydrofluoric acid is one kind of strong acids that corrode a stable material, and by combination with nitric acid having strong oxidizing properties, it is expected to efficiently remove even the oxide film 12 that is very stable and cannot be removed by a typical acid.

However, only removal of the oxide film 12 was insufficient for a degree of securing adhesiveness of the chromatic color film and the transparent resin coat 24, and after much trial and error under a variety of conditions, preferred ranges of a mixed ratio, concentration, temperature and time were found and further, the surface active treatment conditions were optimized, to complete the present invention.

As thus described, the surface active treatment for removing the oxide film 12 and providing the anchor bond shape 14 in atomic unit is performed by reacting the surface with the aqueous solution of nitric acid and hydrofluoric acid 18. The plating film 16 and the metal deposition film 20 are formed, physical polishing is performed, and the transparent resin coat 24 is further formed. Then, a metallic glass surface layer having both durability and a chromatic color is made.

Moreover, the metallic glass component 10 with the surface layer having both durability and a chromatic color can be made by making up of the transparent resin coat 24 on the surface of the metallic glass component 10, on which physical polishing is performed.

### Brief Description of the Drawings

Figure 1 is a sectional view of surface layers in Embodiments (a) to (c) according to the present invention;
Figure 2 is a section of the surface layer in the embodiment according to the present invention;
Figure 3 is a sectional view of the surface layers in Embodiments (a) and (b) according to the present invention;
Figure 4 is a sectional view of the surface layers in Embodiments (a) and (b) according to the present invention;
Figure 5 is a sectional view of the surface layer in the embodiment according to the present invention; and
Figure 6 is a sectional view of the surface layer in the embodiment according to the present invention.

### Description of the Preferred Embodiments

(a), (b), and (c) in Figure 1 show embodiments of the present invention, respectively showing cross sections of a surface layer (a) before surface active treatment for removing an oxide film 12 formed on the surface of the metallic glass component 10 of Zr group and for providing an anchor bond shape 14 on the surface of a metallic glass component 10, (b) after the treatment, and (c) after subsequent formation of the plating film 16.

It is to be noted that the metallic glass is not restricted to metallic glass of Zr group, but metallic glass of Zr group, Ti, group, Cu group, Ni group, or Fe group containing Zr, Ti, Cu, Ni or Fe as a constituent in the largest amount may be used. The reason these five kinds of metallic glass are considered as preferable for the present invention is that those five kinds of metallic glass have high reactive susceptibility to the mixed aqueous solution of nitric acid and hydrofluoric acid while having excellent durability and mechanical strength among metallic glass, and abundantly exist also as ore resources in the surface layer of the earth, making a raw material relatively cheep, so as to be cost-effective.

The surface active treatment is to remove the oxide film 12 and form an anchor bond shape 14 in an atomic level (namely, fine projections and depressions formed on the surface) on the surface of the metallic glass component 10 by reacting the surface with a mixed aqueous solution of nitric acid and hydrofluoric acid 18, prepared such that a volumetric ratio of nitric acid to hydrofluoric acid is in the range of two to five and the concentration of the mixed aqueous solution of nitric acid and hydrofluoric acid is 1 to 10% in a volumetric ratio. The mixed aqueous solution of nitric acid and hydrofluoric acid 18 is used for strengthening the oxidation properties of hydrofluoric acid as a strong acid to efficiently remove the oxide film 12 so as to activate the surface and form the anchor bond shape. Further, the surface active treatment is preferably performed with an aqueous solution at a temperature in the range of not lower than 10°C and not higher than 40°C in the reaction time in the range of five minutes to 24 hours.

Further, the reason the volumetric ratio of nitric acid to hydrofluoric acid is restricted to two to five is that the effect of activation is not significantly observed in a volumetric ratio below two, and the effect does not increase even by excessive addition of nitric acid in the volumetric ratio not smaller than five. The volumetric ratio may be appropriately selected in the preferred range of two to five in accordance with the composition of the metallic glass component 10.

The reason of the aqueous solution concentration is restricted is that activation does not occur in the case of the concentration being lower than 1% and an excessive reaction occurs and the surface becomes rougher in the case of the concentration exceeding 10%.

The reason of the aqueous solution temperature is restricted is that the reaction rate extremely decreases in the case of the temperature below 10°C, and conversely, the reaction rate increases in the case of the temperature exceeding 40°C.

Although the reaction time depends upon the mixture composition, concentration and temperature of the aqueous solution, sufficient activation is not obtained in the time shorter than five minutes even when the condition of the maximum reaction rate is selected, whereas sufficient activation is obtained in the order of 24 hours even when the condition of the minimum rate is selected with importance placed on uniformity and a significant progress cannot be expected even by the treatment over 24 hours, which is cost-ineffective.

Further, electroplating or electroless plating is used for forming the plating film 16, and trivalent chromium to become a chromatic color, nickel, gold, silver, platinum, copper, palladium and the like are typically selected, but the such use and selection are not restricted. Moreover, a plating bath may previously contain Teflon (registered trademark) or the like. Plating treatment is performed by conventionally performed electroplating or electroless plating.

Figure 2 shows another embodiment of the present invention, in which the metal deposition film 20 was deposited and formed by vacuum deposition on the upper surface of the metallic glass component 10 where the foregoing surface active treatment for removing the oxide film 12 and providing the anchor bond shape 14 had been performed. Figure 2 shows a sectional view of that surface layer.

Ion plating, sputtering or some other dry plating methods can be used for the method for deposition. As the metal to be deposited, chromium as a chromatic color, nickel, gold, silver, platinum, palladium and the like are typically selected, but the metal to be deposited are not restricted thereto.

(a) and (b) in Figure 3 show sectional views of the surface layer where, after the surface active treatment, the polished face 22 was formed on the surface of the metallic glass component 10 by physical polishing such as shotblast or barrel-rotation polishing, and subsequently, (a) the plating film 16 or (b) the metal deposition film 20 is formed. It is to be noted that the polishing method is not restricted to this, but buffing or sandblast may also be used.

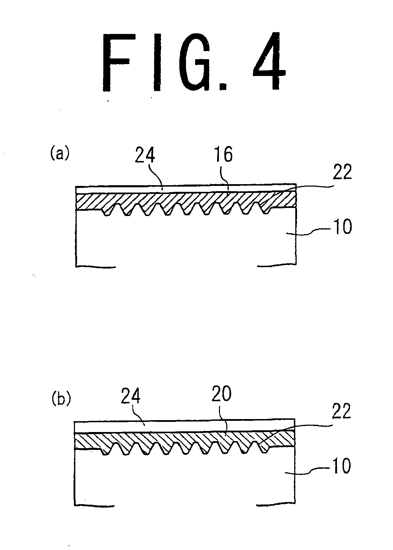

(a) and (b) in Figure 4 show cross sectional views of the surface layer where, after the surface active treatment, the polished face 22 was formed on the surface of the metallic glass component 10 by physical polishing such as shotblast or barrel-rotation polishing, followed by formation of (a) the plating film 16 or (b) the metal deposition film 20 and spray coating with a transparent acrylic resin called "clear coat" on the film, to form the transparent resin coat 24.

The coating method is not restricted to splaying, but blushing, roller coating, immersion, printing or the like may be used. Further, not only the entire surface may be uniformly coated as thus described, but also an arbitrary area may be coated. Although the transparent acrylic resin is typically used for the transparent resin coat 24, the material for the transparent resin coat 24 is not restricted thereto, but a solution having sufficient transparency and self-hardening properties may be applied.

Further, the thickness of the transparent resin coat 24 is preferably not smaller than 1 µm and not larger than 10 µm. The reason of the thickness is restricted is that bubbles are left in the coat when the solution is applied in the case of the thickness exceeding 10 µm, and hence transparency is reduced and enough flexibility to follow transformation of a component at the time of bending is not obtained, thereby leading to breaking of the film. On the other hand, when the thickness is below 1 µm, the surface of the metallic glass component 10 to locally become a substrate might be exposed at the time of coating by the coating method as described above, and the reliability is impaired.

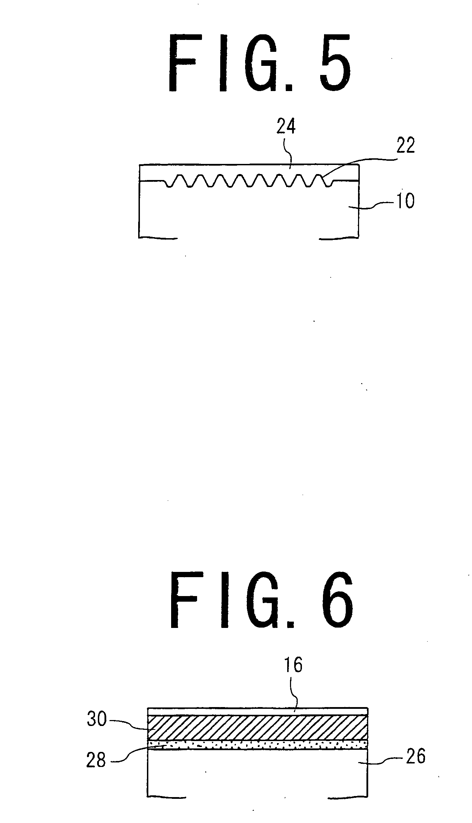

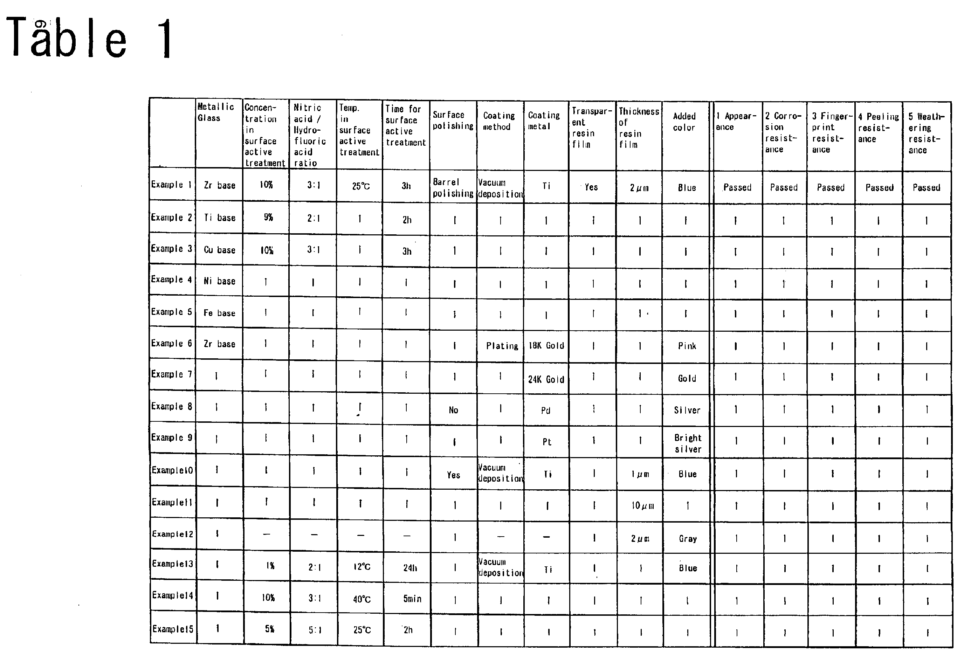

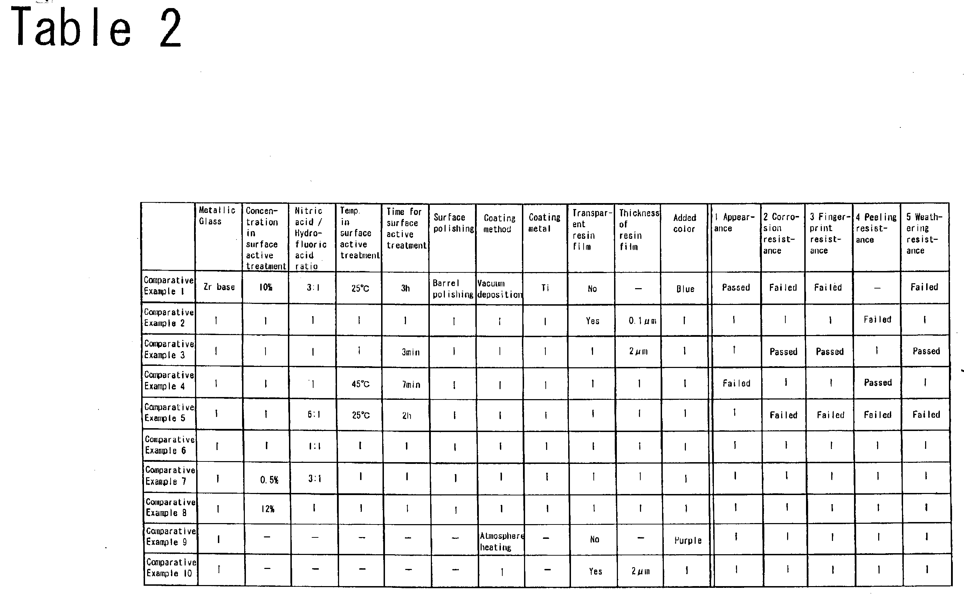

Figure 5 shows a sectional view of the surface layer where, after the surface active treatment, the polished face 22 is formed by physical polishing such as shotblast or barrel-rotation polishing, which provides metal gloss color and then spray-coated with a transparent acryl coat resin to form the transparent resin coat 24.

Figure 6 shows a sectional view of the surface layer where a primary Ni plating layer 28 is formed on a Zr-Cu-Al-Ni type metallic glass 26, and a Au plating layer 30 as a top layer, and the transparent acryl coating resin is spray-coated to the top surface to form the transparent resin coat 24. As thus described, plating may be constituted of two layers, primary and top plating, and in this case, the combination is not restricted to Ni and Au.

### Examples

Table 1 shows evaluation results of surface layers in Examples 1 to 15 of the present invention, and Table 2 shows those in Comparative Examples 1 to 10.

Examples 1 to 15 are examples in which a surface layer was formed so as to be added with durability and a chromatic color according to the foregoing embodiment of the present invention, and Comparative Examples 1 to 10 are examples where a surface layer was formed out of the conditions for the embodiment of the present invention or by the conventional method.

Evaluations of the surface layers were obtained as a result that, after treatment of a specimen in size of 60 mm x 45 mm as in the examples and the comparative examples, in addition to judgment as to (1) appearance uniformity by visual viewing, evaluation of (2) corrosion resistance (chemical resistance), (3) fingerprinting resistance (4) weathering resistance, and (5) peeling resistance of a coated film by an acceleration test were performed.

The corrosion resistance evaluation is an evaluation visually made as to whether the surface changed at the time of immersion into a 0.5% dilute nitric aqueous solution such that the surface was evaluated as "passed" when there was no change, and as "failed" when there was a change.

For the fingerprinting resistance evaluation, a test was conducted where fingerprints were put all over the surface of the specimen, the specimen was left in the atmosphere at constant temperature for 24 hours, and the fingerprints were then wiped out with a felt cloth. It was evaluated as "passed" when the fingerprints were completely wiped out, and as "failed" when a mineral or the like within the fingerprint even in a small amount was left.

For the weathering resistance evaluation, the specimen was subjected to an outside exposure test for 30 days, followed by washing with water, and whether or not there was a corrosion product or the like exists on the surface was visually determined. It was evaluated as "passed" when no corrosion product existed, and as "failed" when the product, even in a small amount was recognized.

For the film peeling resistance evaluation, an adhesive tape was placed all over the surface of the specimen, and at the time of peeling the tape, it was evaluated as "passed" when there was no damage on the surface layer film and as "failed" when damage was recognized. When visual judgment was difficult, the foregoing corrosion resistance evaluation was performed for judgment after peeling of the adhesive tape.

**Table 1**

| | Metallic Glass | Concentration in surface active treatment | Nitric acid Hydro-fluoric acid ratio | Temp. in surface active treatment | time for surface active treatment | Surface polishing | Coating method | Coating metal | Transparent resin film | Thickness of resin film | Added color | 1 Appearance | 2 Corrosion resist ance | 3 Finger-print resistance | 4 Peeling resistance | 5 Heathering resistance |
|---|---|---|---|---|---|---|---|---|---|---|---|---|---|---|---|---|
| Example 1 | Zr base | 10% | 3:1 | 25°C | 3h | Barrel polishing | Vacuum deposition | Ti | Yes | 2µm | Blue | Passed | Passed | Passed | Passed | Passed |
| Example 2 | Ti base | 9% | 2:1 | ↑ | 2h | ↑ | ↑ | ↑ | ↑ | ↑ | ↑ | ↑ | ↑ | ↑ | ↑ | ↑ |
| Example 3 | Cu base | 10% | 3:1: | ↑ | 3h | ↑ | ↑ | ↑ | ↑ | ↑ | ↑ | ↑ | ↑ | ↑ | ↑ | ↑ |
| Example 4 | Ni base | ↑ | ↑ | ↑ | ↑ | ↑ | ↑ | ↑ | ↑ | ↑ | ↑ | ↑ | ↑ | ↑ | ↑ | ↑ |
| Example 5 | Fe base | ↑ | ↑ | ↑ | ↑ | ↑ | ↑ | ↑ | ↑ | ↑ | ↑ | ↑ | ↑ | ↑ | ↑ | ↑ |
| Example 6 | Zr base | ↑ | ↑ | ↑ | ↑ | ↑ | Plating | 18K Gold | ↑ | ↑ | Pink | ↑ | ↑ | ↑ | ↑ | ↑ |
| Example 7 | ↑ | ↑ | ↑ | ↑ | ↑ | ↑ | ↑ | 24K Gold | ↑ | ↑ | Gold | ↑ | ↑ | ↑ | ↑ | ↑ |
| Example 8 | ↑ | ↑ | ↑ | ↑ | ↑ | No | ↑ | Pd | ↑ | ↑ | Silver | ↑ | ↑ | ↑ | ↑ | ↑ |
| Example 9 | ↑ | ↑ | ↑ | ↑ | ↑ | ↑ | ↑ | Pt | ↑ | ↑ | Bright silver | ↑ | ↑ | ↑ | ↑ | ↑ |
| Example 10 | ↑ | ↑ | ↑ | ↑ | ↑ | Yes | Vacuum deposition | ti | ↑ | 1*µ*m | Blue | ↑ | ↑ | ↑ | ↑ | ↑ |
| Example 11 | ↑ | ↑ | ↑ | ↑ | ↑ | ↑ | ↑ | ↑ | ↑ | 10 *µ*m | ↑ | ↑ | ↑ | ↑ | ↑ | ↑ |
| Example 13 | ↑ | 1% | 2:1 | 12°C | 24h | ↑ | Vacuum deposition | ti | ↑ | ↑ | Blue | ↑ | ↑ | ↑ | ↑ | ↑ |
| Example 14 | ↑ | 10% | 3:1 | 40°C | 5min | ↑ | ↑ | ↑ | ↑ | ↑ | ↑ | ↑ | ↑ | ↑ | ↑ | ↑ |
| Example 15 | ↑ | 5% | 5:1 | 25°C | 2h | ↑ | ↑ | ↑ | ↑ | ↑ | ↑ | ↑ | ↑ | ↑ | ↑ | ↑ |

**Table 2**

| | Metallic Glass | Concentration in surface active treatment | Nitric acid ; Hydrofluoric acid ratio | Temp. in surface active treatment | Time for surface active treatment | Surface polishing | Coating method | Coating metal | Transparent resin film | Thickness of resin film | Added color | 1 Appearance | 2 Corrosion resistance | 3 Finger- print resistance | 4 Peeling resistance | 5 Heathering resistance |
|---|---|---|---|---|---|---|---|---|---|---|---|---|---|---|---|---|
| Comparative Example 1 | Zr base | 10% | 3:1 | 25°C | 3h | Barrel polishing | Vacuum deposition | Ti | No | - | Blue | Passed | Failed | Failed | - | Failed |
| Comparative Example 2 | ↑ | ↑ | ↑ | ↑ | ↑ | ↑ | ↑ | ↑ | Yes | 0.1µm | ↑ | ↑ | ↑ | ↑ | failed | ↑ |
| Comparative Example 3 | ↑ | ↑ | ↑ | ↑ | 3min | ↑ | ↑ | ↑ | ↑ | 2*µ*m | ↑ | ↑ | Passed | Passed | ↑ | Passed |
| Comparative Example 4 | ↑ | ↑ | ↑ | 45°C | 7min | ↑ | ↑ | ↑ | ↑ | ↑ | ↑ | Failed | ↑ | ↑ | Passed | ↑ |
| Comparative Example 5 | ↑ | ↑ | 6:1 | 25°C | 2h | ↑ | ↑ | ↑ | ↑ | ↑ | ↑ | ↑ | Failed | Failed | Failed | Failed |
| Comparative Example 6 | ↑ | ↑ | 1:1 | ↑ | ↑ | ↑ | ↑ | ↑ | ↑ | ↑ | ↑ | ↑ | ↑ | ↑ | ↑ | ↑ |
| Comparative Example 7 | ↑ | 0.5% | 3:1 | ↑ | ↑ | ↑ | ↑ | ↑ | ↑ | ↑ | ↑ | ↑ | ↑ | ↑ | ↑ | ↑ |
| Comparative Example 8 | ↑ | 12% | ↑ | ↑ | ↑ | ↑ | ↑ | ↑ | ↑ | ↑ | ↑ | ↑ | ↑ | ↑ | ↑ | ↑ |
| Comparative Example 9 | ↑ | - | - | - | - | - | Atmosphere heating | - | No | - | Purple | ↑ | ↑ | ↑ | ↑ | ↑ |
| Comparative Example 10 | ↑ | - | - | - | - | - | ↑ | - | Yes | 2*µ*m | ↑ | ↑ | ↑ | ↑ | ↑ | ↑ |

It was confirmed as a result of the test that in all Examples, the surface layer which have corrosion resistance, weathering resistance and fingerprint resistance, a uniform chromatic color, and being resistant to peeling was formed.

Moreover, it was confirmed that in all Comparative examples, the surface layer was evaluated as "failed" in any of the evaluation items.

## Claims

1. A surface treatment method for a metallic glass component 10, comprising:
removing an oxide film 12 on a surface of the metallic glass component 10 and providing an anchor bond shape 14 on the surface of the metallic glass component 10 by surface active treatment with a mixed aqueous solution of nitric acid and hydrofluoric acid 18 wherein a volumetric ratio of the nitric acid to the hydrofluoric acid is in a range of 2 to 5, and the mixed aqueous solution of nitric acid and hydrofluoric acid 18 has a concentration of 1 to 10 % in a volumetric ratio; and
forming a plating film 16 on the surface of the metallic glass component 10 by electroplating or electroless plating.

2. A surface treatment method for a metallic glass component 10, comprising:
removing an oxide film 12 on a surface of the metallic glass component 10 and providing an anchor bond shape 14 on the surface of the metallic glass component 10 by surface active treatment with a mixed aqueous solution of nitric acid and hydrofluoric acid 18 wherein a volumetric ratio of the nitric acid to the hydrofluoric acid is in a range of 2 to 5, and the mixed aqueous solution of nitric acid and hydrofluoric acid 18 has a concentration of 1 to 10 % in a volumetric ratio; and
forming a metal deposition film 20 uniformly on the surface of the metallic glass component 10 by a dry plating method such as vacuum deposition, ion plating or sputtering.

3. The surface treatment method for a metallic glass component 10 according to claim 1 or 2, further comprising:
adjusting a surface roughness by physical polishing between the surface active treatment and the electroplating, the electroless plating or the dry plating method.

4. The surface treatment method for a metallic glass component 10 according to any one of claims 1 to 3, further comprising:
forming a transparent resin coat 24 by applying transparent resin after the electroplating, the electroless plating or the dry plating method.

5. A surface treatment method for a metallic glass component 10, comprising:
removing an oxide film 12 on a surface of the metallic glass component 10 and providing an anchor bond shape 14 on the surface of the metallic glass component 10 by surface active treatment with a mixed aqueous solution of nitric acid and hydrofluoric acid 18 wherein a volumetric ratio of the nitric acid to the hydrofluoric acid is in a range of 2 to 5, and the mixed aqueous solution of nitric acid and hydrofluoric acid 18 has a concentration of 1 to 10 % in a volumetric ratio;
adding a metal gloss color to the surface of the metallic glass component 10 by physical polishing;
forming a resin coat 24 to the surface of the metallic glass component 10 by applying resin.

6. The surface treatment method for a metallic glass component 10 according to claim 4 or 5, wherein,
the transparent resin coat 24 or the resin coat 24 has a thickness of not less than 1 µm and not more than 10 µm.

7. The surface treatment method for a metallic glass component 10 according to any one of claims 1 to 6, wherein,
the metallic glass component 10 is Zr based, Ti based, Cu based, Ni based or Fe based.

8. A metallic glass component 10, wherein the surface thereof is treated by any one of methods according to claims 1 to 7.

## Patentansprüche

1. Verfahren zur Oberflächenbehandlung für ein Einzelteil aus metallischem Glas 10, umfassend
das Entfernen eines Oxidfilms 12 auf einer Oberfläche des Einzelteils aus metallischem Glas 10 und das Bereitstellen einer Verankerungsbondierkontur 14 auf der Oberfläche des Einzelteils aus metallischem Glas 10 durch oberflächenaktive Behandlung mit einer gemischten wässrigen Lösung von Salpetersäure und Fluorwasserstoffsäure 18, wobei ein volumetrisches Verhältnis der Salpetersäure zur Fluorwasserstoffsäure in einem Bereich von 2 bis 5 liegt und die gemischte wässrige Lösung von Salpetersäure und Fluorwasserstoffsäure 18 eine Konzentration von 1 bis 10 %, in einem volumetrischen Verhältnis, aufweist; und
das Bilden eines Plattierfilms 16 auf der Oberfläche des Einzelteils aus metallischem Glas 10 durch Elektroplattieren oder elektrofreies Plattieren.

2. Verfahren zur Oberflächenbehandlung für ein Einzelteil aus metallischem Glas 10, umfassend
das Entfernen eines Oxidfilms 12 auf einer Oberfläche des Einzelteils aus metallischem Glas 10 und das Bereitstellen einer Verankerungsbondierkontur 14 auf der Oberfläche des Einzelteils aus metallischem Glas 10 durch oberflächenaktive Behandlung mit einer gemischten wässrigen Lösung von Salpetersäure und Fluorwasserstoffsäure 18, wobei ein volumetrisches Verhältnis der Salpetersäure zur Fluorwasserstoffsäure in einem Bereich von 2 bis 5 liegt und die gemischte wässrige Lösung von Salpetersäure und Fluorwasserstoffsäure 18 eine Konzentration von 1 bis 10 %, in einem volumetrischen Verhältnis, aufweist; und
das Bilden eines Metallabscheidungsfilms 20 gleichförmig auf der Oberfläche des Einzelteils aus metallischem Glas 10 durch ein Trockenplattierverfahren wie Gasphasenabscheidung, Ionenplattierung oder Sputtern.

3. Verfahren zur Oberflächenbehandlung für ein Einzelteil aus metallischem Glas 10 nach Anspruch 1 oder 2, des Weiteren folgendes umfassend:
das Einstellen einer Oberflächenrauheit durch physikalisches Polieren zwischen der oberflächenaktiven Behandlung und dem Elektroplattier-, dem elektrofreien Plattier- oder dem Trockenplattierverfahren.

4. Verfahren zur Oberflächenbehandlung für ein Einzelteil aus metallischem Glas 10 nach einem der Ansprüche 1 bis 3, des Weiteren Folgendes umfassend:
das Bilden eines transparenten Harzbelags 24 durch Aufbringen eines transparenten Harzes nach dem Elektroplattier-, dem elektrofreien Plattier- oder dem Trockenplattierverfahren.

5. Verfahren zur Oberflächenbehandlung für ein Einzelteil aus metallischem Glas 10, umfassend
das Entfernen eines Oxidfilms 12 auf einer Oberfläche des Einzelteils aus metallischem Glas 10 und das Bereitstellen einer Verankerungsbondierkontur 14 auf der Oberfläche des Einzelteils aus metallischem Glas 10 durch oberflächenaktive Behandlung mit einer gemischten wässrigen Lösung von Salpetersäure und Fluorwasserstoffsäure 18, wobei ein volumetrisches Verhältnis der Salpetersäure zur Fluorwasserstoffsäure in einem Bereich von 2 bis 5 liegt und die gemischte wässrige Lösung von Salpetersäure und Fluorwasserstoffsäure 18 eine Konzentration von 1 bis 10 %, in einem volumetrischen Verhältnis, aufweist;
das Hinzufügen einer Metallglanzfarbe auf die Oberfläche des Einzelteils aus metallischem Glas 10 durch physikalisches Polieren;
das Bilden eines Harzbelags 24 auf der Oberfläche des Einzelteils aus metallischem Glas 10 durch Aufbringen von Harz.

6. Verfahren zur Oberflächenbehandlung für ein Einzelteil aus metallischem Glas 10 nach Anspruch 4 oder 5, wobei
der transparente Harzbelag 24 oder der Harzbelag 24 eine Dicke von nicht weniger als 1 µm und nicht mehr als 10 µm aufweist.

7. Verfahren zur Oberflächenbehandlung für ein Einzelteil aus metallischem Glas 10 nach einem der Ansprüche 1 bis 6, wobei
das Einzelteil aus metallischem Glas 10 auf Zr, Ti, Cu, Ni oder Fe basiert.

8. Einzelteil aus metallischem Glas 10, wobei die Oberfläche derselben durch irgendeines der Verfahren nach den Ansprüchen 1 bis 7 behandelt wird.

## Revendications

1. Procédé de traitement de surface pour un composant de verre métallique 10, comprenant :
l'élimination d'un film d'oxyde 12 d'une surface du composant de verre métallique 10 et la fourniture d'un profilé d'ancrage de liaison 14 sur la surface du composant de verre métallique 10 par traitement actif de surface avec une solution aqueuse mixte d'acide nitrique et d'acide fluorhydrique 18 dans lequel un rapport volumétrique de l'acide nitrique à l'acide fluorhydrique est situé dans une plage de 2 à 5, et la solution aqueuse mixte d'acide nitrique et d'acide fluorhydrique 18 a une concentration de 1 à 10 % en un rapport volumétrique ; et
la formation d'un film de placage 16 sur la surface du composant de verre métallique 10 par dépôt électrolytique ou dépôt autocatalytique.

2. Procédé de traitement de surface pour un composant de verre métallique 10, comprenant :
l'élimination d'un film d'oxyde 12 d'une surface du composant de verre métallique 10 et la fourniture d'un profilé d'ancrage de liaison 14 sur la surface du composant de verre métallique 10 par traitement actif de surface avec une solution aqueuse mixte d'acide nitrique et d'acide fluorhydrique 18 dans lequel un rapport volumétrique de l'acide nitrique à l'acide fluorhydrique est situé dans une plage de 2 à 5, et la solution aqueuse mixte d'acide nitrique et d'acide fluorhydrique 18 a une concentration de 1 à 10 % en un rapport volumétrique ; et
la formation d'un film de dépôt métallique 20 uniformément sur la surface du composant de verre métallique 10 par un procédé de placage à sec tel que le dépôt sous vide, le placage ionique ou la pulvérisation cathodique.

3. Procédé de traitement de surface pour un composant de verre métallique 10 selon la revendication 1 ou 2, comprenant en outre :
l'ajustement d'une rugosité de surface par polissage physique entre le traitement actif de surface et le dépôt électrolytique, le dépôt autocatalytique ou le procédé de placage à sec.

4. Procédé de traitement de surface pour un composant de verre métallique 10 selon l'une quelconque des revendications 1 à 3, comprenant en outre :
la formation d'un revêtement transparent de résine 24 par l'application de résine transparente après le dépôt électrolytique, le dépôt autocatalytique ou le procédé de placage à sec.

5. Procédé de traitement de surface pour un composant de verre métallique 10, comprenant :
l'élimination d'un film d'oxyde 12 sur une surface du composant de verre métallique 10 et la fourniture d'un profilé d'ancrage de liaison 14 sur la surface du composant de verre métallique 10 par traitement actif de surface avec une solution aqueuse mixte d'acide nitrique et d'acide fluorhydrique 18 dans lequel un rapport volumétrique de l'acide nitrique à l'acide fluorhydrique se situe dans une plage de 2 à 5, et la solution aqueuse mixte d'acide nitrique et d'acide fluorhydrique 18 a une concentration de 1 à 10 % en un rapport volumétrique ;
l'ajout d'une couleur lustrée métallique à la surface du composant de verre métallique 10 par polissage physique ;
la formation d'une couche de résine 24 sur la surface du composant de verre métallique 10 par l'application de résine.

6. Procédé de traitement de surface pour un composant de verre métallique 10 selon la revendication 4 ou 5, dans lequel
la couche de résine transparente 24 ou la couche de résine 24 a une épaisseur non inférieure à 1 µm et non supérieure à 10 µm

7. Procédé de traitement de surface pour un composant de verre métallique 10 selon l'une quelconque des revendications 1 à 6, dans lequel,
le composant de verre métallique 10 est à base de Zr, à base de Ti, à base de Cu, à base de Ni ou à base de Fe.

8. Composant de verre métallique 10, dans lequel la surface de celui-ci est traitée selon l'un quelconque des procédés selon les revendications 1 à 7.
